# FASCICULE DE BREVET EUROPEEN

(11) **EP 1 671 330 B1**
(45) Date de publication et mention de la délivrance du brevet: **18.03.2015**
(21) Numéro de dépôt: 04791472.6
(22) Date de dépôt: 06.10.2004
(51) Int. Cl.: B82Y 25/00, H01F 10/32, H01L 43/08, G11C 11/16

(54) **DISPOSITIF A JONCTION TUNNEL MAGNETIQUE ET PROCEDE D'ECRITURE/LECTURE D'UN TEL DISPOSITIF**
MAGNETTUNNEL-SPERRSCHICHTBAUELEMENT UND SCHREIB-/LESEVERFAHREN FÜR DAS BAUELEMENT
MAGNETIC TUNNEL JUNCTION DEVICE AND WRITING/READING METHOD FOR SAID DEVICE

(30) Priorité: 10.10.2003 FR 0311897
(43) Date de publication de la demande: 21.06.2006
(73) Titulaire: Commissariat à l'Énergie Atomique et aux Énergies Alternatives, 75015 Paris (FR); Centre National de la Recherche Scientifique, 75794 Paris Cedex 16 (FR)
(72) Inventeur: DIENY, Bernard, F-38250 Lans en Vercors (FR); SOUSA, Ricardo, F-38000 Grenoble (FR); STANESCU, Dana, F-38000 Grenoble (FR)
(74) Mandataire: Santarelli
(86) Numéro de dépôt international: PCT/FR2004/002517
(87) Numéro de publication internationale: WO 2005/036559

(56) Documents cités:
- WO-A-00/79540
- WO-A-03/077257
- WO-A-03/094170
- WO-A-2005/001490
- FR-A- 2 829 867
- FR-A- 2 832 542
- US-A- 5 933 365
- US-A1- 2003 007 398
- US-A1- 2003 123 282
- US-A1- 2004 095 801
- US-B1- 6 385 082
- BOULOUZ A ET AL: "PREPARATION AND CHARACTERIZATION OF MOCVD BISMUTH TELLURIDE THIN FILMS" JOURNAL OF CRYSTAL GROWTH, NORTH-HOLLAND PUBLISHING CO. AMSTERDAM, NL, vol. 194, no. 3/4, décembre 1998 (1998-12), pages 336-341, XP000669099 ISSN: 0022-0248
- ZOU H ET AL: "Growth of p- and n-type bismuth telluride thin films by co-evaporation" JOURNAL OF CRYSTAL GROWTH, NORTH-HOLLAND PUBLISHING CO. AMSTERDAM, NL, vol. 222, no. 1-2, janvier 2001 (2001-01), pages 82-87, XP004228292 ISSN: 0022-0248
- PATENT ABSTRACTS OF JAPAN vol. 1999, no. 12, 29 octobre 1999 (1999-10-29) & JP 11 175921 A (HITACHI LTD), 2 juillet 1999 (1999-07-02)
- DIENY;SOUSA: "Bias current heating in spin dependent tunnel junctions" 26 septembre 2003 (2003-09-26), MINATEC 2003 , GRENOBLE, FRANCE , XP002280171 le document en entier

## Description

### Domaine technique de l'invention

L'invention concerne un dispositif magnétique comportant successivement
- une première électrode,
- une jonction tunnel magnétique comportant successivement une première couche magnétique formant une couche de référence et ayant une aimantation fixe, une couche électriquement isolante constituant une barrière tunnel et une seconde couche magnétique formant une couche de stockage et ayant une aimantation de direction réversible,
- une couche intermédiaire,
- et une seconde électrode.

### État de la technique

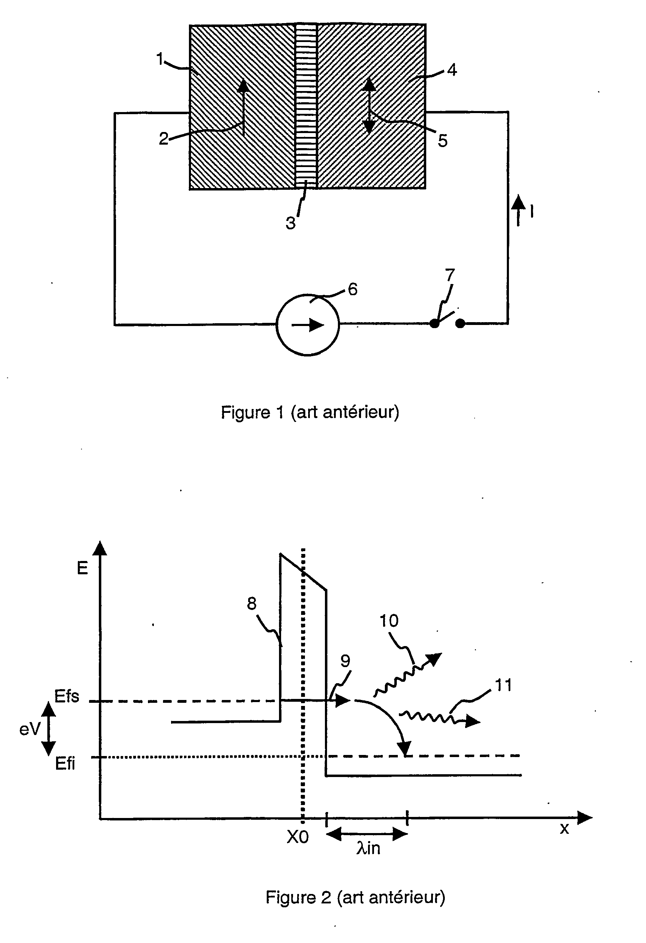

Le document FR2832542 décrit un dispositif magnétique à jonction tunnel magnétique et des procédés d'écriture et de lecture utilisant ce dispositif. Comme représenté à la figure 1, la jonction tunnel comporte successivement une première couche magnétique formant une couche de référence 1 et ayant une aimantation 2 fixe, une couche électriquement isolante constituant une barrière tunnel 3 et une seconde couche magnétique formant une couche de stockage 4 et ayant une aimantation 5 de direction réversible, représentée par une flèche bidirectionnelle sur la figure 1. L'aimantation 5 de direction réversible de la couche de stockage 4 peut être orientée par rapport à l'aimantation 2 fixe de la couche de référence 1, de manière à ce que les aimantations soient parallèles ou antiparallèles.

La température de blocage de l'aimantation de la couche de stockage 4 est inférieure à la température de blocage de la couche de référence 1. Le dispositif comprend aussi une source de courant 6, un interrupteur 7 et des moyens (non-représentés) pour appliquer un champ magnétique à la couche de stockage et, ainsi, orienter l'aimantation 5 de la couche de stockage 4 par rapport à l'aimantation 2 de la couche de référence 1 sans modifier l'orientation de l'aimantation 2 de la couche de référence 1.

Lors d'une phase d'écriture, c'est-à-dire lors d'une phase d'aimantation de la couche de stockage 4 par application d'un champ magnétique extérieur, on fait circuler un courant électrique I, à travers la jonction tunnel, pour chauffer la couche de stockage 4 au-delà de la température de blocage de son aimantation 5.

Lors d'une phase de lecture, l'orientation de l'aimantation 5 de la couche de stockage 4 par rapport à celle de la couche de référence 1 est mesurée par l'intermédiaire de la résistance de la jonction tunnel magnétique, qui dépend de l'orientation de l'aimantation 5 de la couche de stockage 4 par rapport à celle de la couche de référence 1.

Pendant l'écriture, une tension de l'ordre de 0,5 V est appliquée aux bornes de la jonction, nécessitant une puissance électrique relativement élevée. Par ailleurs, la jonction peut être endommagée par cette puissance. La tension appliquée pour la lecture est typiquement de 0,3V. La jonction tunnel est alors également chauffée pendant la lecture, ce qui augmente le risque d'une écriture inopinée.

La figure 2 représente l'énergie potentielle 8 des électrons dans une jonction tunnel soumise à une différence de potentiel V. La jonction est constituée par une couche émettrice d'électrons et une couche réceptrice d'électrons, disposées de part et d'autre de la barrière tunnel placée à X0 et ayant respectivement des niveaux de Fermi supérieur Efs et inférieur Efi. La différence des niveaux de Fermi est proportionnelle à la différence de potentiel : Efs-Efi=eV, e étant la charge élémentaire de l'électron. Comme illustré par la flèche 9, un électron émis par la couche émettrice traverse la barrière tunnel, par effet tunnel, sans dissiper de l'énergie. Ensuite, lors de la relaxation inélastique de l'électron d'une énergie supérieure Efs vers une énergie inférieure Efi, l'électron dissipe l'énergie eV dans la couche réceptrice d'électrons, par exemple par création de phonons 10 et/ou de magnons 11, ce qui augmente la température de la couche réceptrice d'électrons. La relaxation inélastique a lieu sur une longueur caractéristique, le libre parcours moyen inélastique λin, qui est typiquement de l'ordre de quelques nanomètres dans les matériaux magnétiques usuellement utilisés dans les jonctions tunnel magnétiques. Ainsi, la production de chaleur par le courant tunnel est maximale dans une zone d'une épaisseur de quelques nanomètres, localisée dans la couche réceptrice et adjacente à la barrière tunnel.

La jonction tunnel décrite dans le document FR2832542 peut également comporter une couche antiferromagnétique, par exemple en NiMn, disposée sur une face opposée à la barrière tunnel de la couche de référence de la jonction tunnel. De plus, sur une face opposée à la barrière tunnel de la couche de stockage de la jonction tunnel peut également être disposée une couche antiferromagnétique, par exemple en FeMn ou en Ir20Mn80. Les couches antiferromagnétiques remplissent la fonction de maintenir l'orientation magnétique des couches de stockage et de référence. Le dépôt des couches constituant la jonction tunnel sur la couche antiferromagnétique et la nanostructuration des jonctions nécessitent éventuellement des étapes supplémentaires, par exemple une étape d'alignement. De plus, le risque d'un court-circuit de la barrière tunnel est augmenté.

Le document WO00/79540 décrit une mémoire magnétique constituée par un empilement de couches minces. Le document propose d'isoler thermiquement des cellules mémoire afin de permettre d'atteindre une température Curie avec un courant électrique de chauffage réduit, notamment par l'intermédiaire d'une couche d'isolation thermique ayant une conductivité électrique suffisante tout en ayant une conductivité thermique faible par rapport à l'aluminium. Le matériau de la couche d'isolation thermique est, par exemple, un composé de tantale et d'azote (TaN) ou du tungstène (W).

Le document WO 2005/01490 opposable en Allemagne et en Grande-Bretagne en vertu de l'Article 54(3) et 54(4) CBE décrit un dispositif magnétique comportant successivement une première électrode, deux jonctions tunnel magnétique partageant une seule couche de stockage ayant une aimantation de direction réversible et une seconde électrode. Chaque jonction tunnel magnétique comporte en outre une couche de référence à aimantation fixe et une couche électriquement isolante entre la couche de référence et la seule couche de stockage, et une couche intermédiaire de piégeage entre la couche de référence et l'électrode concernée, cette couche intermédiaire de piégeage formant également une barrière thermique constituée de PtMn ayant une conductivité thermique de 3W/m/°C ou de CrPtMnB ayant une conductivité thermique de 1W/m/°C. Ce document correspond au préambule de la principale revendication pour l'Allemagne et la Grande-Bretagne.

Cependant, l'introduction d'une telle couche d'isolation thermique présente des problèmes additionnels d'intégration avec la jonction tunnel, à savoir une augmentation de la rugosité de la surface et l'augmentation du temps de gravure nécessaire pour définir le point mémoire. Une telle couche d'isolation thermique nécessiterait des étapes supplémentaires de polissage et gravure, qui compliquent le procédé de dépôt et de fabrication de la jonction.

### Objet de l'Invention

L'invention a pour but de remédier à ces Inconvénients et, en particulier, de réaliser un dispositif permettant de chauffer la couche de stockage efficacement tout en minimisant la puissance électrique nécessaire pour cet échauffement, afin de réduire la consommation électrique du dispositif, et de minimiser le risque d'un court-circuit de la jonction tunnel tout en simplifiant le procédé de fabrication.

Selon l'invention, ce but est atteint par les revendications annexées et, en particulier, par le fait que la couche intermédiaire constitue une première barrière thermique constituée par un matériau ayant une conductivité thermique inférieure à 5W/m/°C.

L'invention a également pour but un procédé de lecture/écriture d'un dispositif magnétique selon l'invention,
- une phase d'écriture comportant la circulation d'un courant électrique, à travers la jonction tunnel, de la seconde couche magnétique vers la première couche magnétique, de manière à échauffer la seconde couche magnétique à une température supérieure à la température de blocage de l'aimantation de la seconde couche magnétique,
- et une phase de lecture comportant la circulation d'un courant électrique, à travers la jonction tunnel, de la première couche magnétique vers la seconde couche magnétique.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 représente un dispositif comportant une jonction tunnel magnétique selon l'art antérieur.
La figure 2 représente les variations d'énergie des électrons dans une jonction tunnel selon l'art antérieur, soumise à une différence de potentiel.
Les figures 3 à 5 représentent trois modes de réalisation particuliers d'un dispositif magnétique selon l'invention.
La figure 6 représente deux distributions de température théoriques dans une jonction tunnel magnétique, respectivement pour un courant circulant de la couche de stockage vers la couche de référence et dans le sens inverse.
Les figures 7 à 9 représentent différentes distributions de température théoriques et correspondent respectivement aux modes de réalisation représentés aux figures 3, 4 et 5.

### Description de modes particuliers de réalisation

Un dispositif magnétique selon l'invention comporte des première et seconde électrodes entre lesquelles est disposée une jonction tunnel telle que celle représentée à la figure 1, une barrière thermique constituée par un matériau ayant une faible conductivité thermique étant en contact avec au moins une des couches magnétiques de la jonction tunnel, de manière à concentrer la chaleur produite par le courant tunnel dans la couche de stockage, pendant les phases d'écriture.

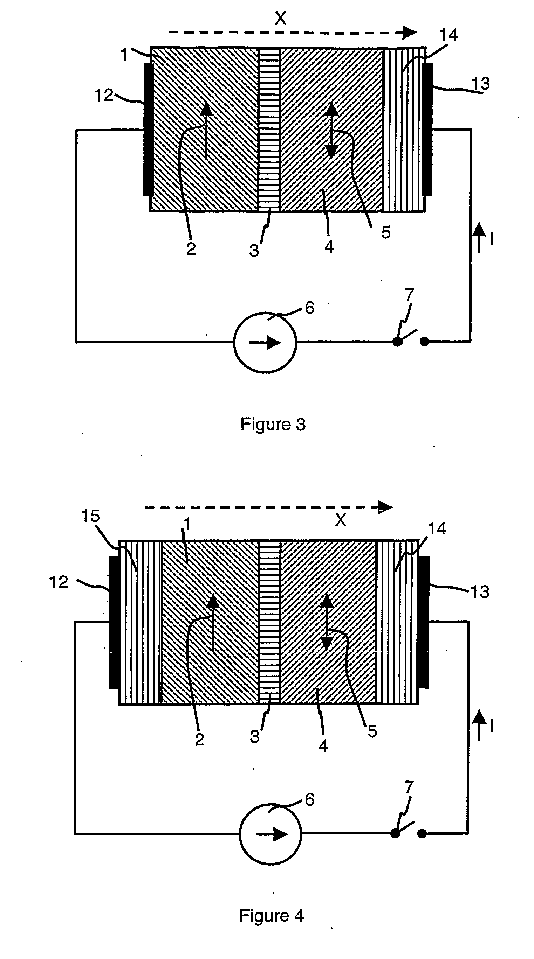

Sur la figure 3, le dispositif magnétique comporte successivement, selon un axe X, la première électrode 12, une jonction tunnel telle que celle représentée à la figure 1, une première barrière thermique et la seconde électrode 13. La première barrière thermique est constituée par une couche 14 intermédiaire disposée entre la couche de stockage 4 et la seconde électrode 13. Les électrodes 12 et 13 sont à température ambiante et permettent de refroidir la jonction tunnel après les phases d'écriture et de lecture.

Selon l'invention, la couche 14 intermédiaire constituant la première barrière thermique est constituée par un matériau ayant une conductivité thermique inférieure à 5W/m/°C. En effet, le dépôt, sur une couche 14 intermédiaire, des couches constituant la jonction tunnel est d'autant plus simple que l'épaisseur de la couche 14 intermédiaire est faible. En particulier, la rugosité d'une couche 14 fine est généralement plus faible et le risque d'un court-circuit d'une jonction tunnel déposée sur une couche 14 fine est réduit. Or, pour une résistance thermique prédéterminée, la couche 14 intermédiaire peut présenter une épaisseur d'autant plus faible que sa conductivité thermique est faible.

Les composés utilisés dans l'art antérieur ne sont pas satisfaisant à cet égard. C'est en particulier le cas du composé de tantale et d'azote (TaN) ou du tungstène (W) mentionnés dans le document WO00/79540 précité, qui ont respectivement une conductivité thermique d'environ 35W/m/°C et d'environ 173W/m/°C. C'est également le cas des couches antiferromagnétiques en FeMn ou en Ir20Mn80 mentionnées dans le document FR2832542 précité, qui ont respectivement des conductivités thermiques de 44 W/m/°C et 35,6 W/m/°C. L'utilisation des couches antiferromagnétiques comme barrière thermique nécessiterait une épaisseur élevée, ce qui rendrait le dépôt des couches constituant la jonction tunnel sur la couche antiferromagnétique et la nanostructuration des jonctions plus difficile.

De plus, les matériaux ayant une conductivité thermique inférieure à 5W/m/°C permettent également d'obtenir une faible capacitance thermique de la barrière thermique, ce qui permet d'obtenir une constante de temps thermique faible. La constante de temps thermique correspond au produit (Rth.Cth) de la résistance thermique Rth d'une barrière thermique et de la capacitance thermique Cth de la barrière thermique. Un gradient thermique peut être établi, lors d'une phase d'écriture, d'autant plus vite que la constante de temps thermique est faible.

Sur la figure 4, en plus de la première barrière thermique, le dispositif comporte une deuxième barrière thermique, constituée par une couche 15 disposée entre la première électrode 12 et la couche de référence 1.

La couche de stockage 4 peut être constituée d'une couche unique de matériau magnétique ou d'une multicouche, dont le champ coercitif diminue rapidement lorsque la température est augmentée, dans un intervalle de température compris entre 20°C et 250°C. Par exemple, le matériau de la couche de stockage peut être un alliage de terbium (Tb) et de cobalt (Co) enrichi en cobalt près de l'interface entre la couche de stockage 4 et de la barrière tunnel 3, ce qui permet d'augmenter la polarisation des électrons traversant la barrière tunnel 3. L'alliage de Tb et de Co a une température de blocage proche de la température ambiante. La couche de stockage 4 peut également être constituée par une multicouche de répétition à aimantation perpendiculaire au plan des couches, par exemple par une alternance de deux couches en cobalt (Co) et en platine (Pt), ayant respectivement une épaisseur de 0,5nm et de 2nm.

De préférence, la couche de stockage 4 est constituée par un empilement d'une couche ferromagnétique et d'une couche antiferromagnétique, par exemple en un composé de fer et de manganèse, par exemple du FeMn, ou en un composé d'iridium et de manganèse, comportant par exemple 20% de Ir et 80% de Mn, ayant une température de blocage comprise entre 130°C et 250°C.

De préférence, les première et/ou deuxième barrières thermiques ont une conductivité électrique telle que la résistance électrique de la barrière thermique soit sensiblement plus faible que la résistance électrique de la barrière tunnel 3, de préférence au moins d'un facteur dix. En effet, la barrière thermique étant connectée en série avec la barrière tunnel 3 le signal de magnétorésistance est d'autant plus faible que la résistance électrique de la barrière thermique est grande.

Le matériau des première et/ou deuxième barrières thermiques comporte, de préférence, au moins un alliage comportant au moins un élément choisi parmi l'arsenic (As), l'antimoine (Sb), le bismuth (Bi), le germanium (Ge), l'étain (Sn) et le plomb (Pb), d'une part, et comportant au moins un élément choisi parmi le soufre (S), le sélénium (Se), le tellure (Te), l'aluminium (Al), le gallium (Ga), l'indium (In) et le thallium (Tl) d'autre part. Ainsi, le matériau des barrières thermiques peut être un alliage de bismuth (Bi) et de tellure (Te), par exemple le BiTe ou le Bi2Te3, qui présente une conductivité électrique relativement bonne d'environ 1,75mΩcm pour une très faible conductivité thermique d'environ 1,5W/m/°C. D'autres exemples pour le matériau des barrières thermiques sont les alliages de thallium, d'étain et de tellure, par exemple Tl2SnTe5, les alliages de thallium, de bismuth et de tellure, par exemple Tl9BiTe6, les alliages de strontium (Sr), de gallium et de germanium, par exemple le Sr8Ga16Ge30, et les alliages de strontium, d'europium (Eu), de gallium et de germanium, par exemple le Sr4Eu4Ga16Ge30. Il est à noter que l'alliage de bismuth et de tellure fait partie des matériaux thermoélectriques qui présentent souvent une conductivité thermique très faible.

Le matériau des barrières thermiques peut également être un matériau à changement de phase, pouvant présenter, à température ambiante, une phase cristalline et une phase amorphe. Typiquement, l'état amorphe présente une forte résistivité électrique, tandis que l'état cristallin présente une résistivité électrique faible. Pour l'utilisation d'un matériau à changement de phase pour les première et/ou deuxième barrières thermiques, le matériau doit être dans son état cristallin. La conductivité thermique des matériaux à changement de phase est typiquement inférieure à 5W/m/°C, dans l'état amorphe et dans l'état cristallin. Par exemple, l'alliage de germanium, d'antimoine et de tellure Ge2Sb2Te5 et l'alliage Sb2Te3 ont respectivement des conductivités thermiques d'environ 0,3W/m/°C et d'environ 1,2W/m/°C. Afin d'obtenir une couche dans un état cristallin, il est généralement nécessaire d'effectuer un traitement thermique. Le traitement thermique est avantageusement effectué avant le dépôt des couches constituant la jonction tunnel.

Le matériau des première et/ou deuxième barrières thermiques peut également être un matériau comportant au moins un alliage comportant au moins un élément choisi parmi le phosphore (P), l'arsenic (As) et l'antimoine (Sb) et comportant au moins un élément choisi parmi le fer (Fe), le ruthénium (Ru), l'osmium (Os), le cobalt (Co), le rhodium (Rh), l'iridium (Ir) et le zinc (Zn), comme, par exemple, les alliages Zn4Sb3 et CoFe4Sb12. De plus, le matériau des première et/ou deuxième barrières thermiques peut comporter au moins un élément choisi parmi le lanthane (La), le cérium (Ce), le praséodyme (Pr), le néodyme (Nd), le samarium (Sm), l'europium (Eu), le gadolinium (Gd), le thulium (Tm), l'ytterbium (Yb), le thorium (Th) et l'uranium (U), comme, par exemple, les alliages Yb0,2Co4Sb12, LaThFe3CoSb12, EuCo4Sb12 et EuCoSb12Ge0,5.

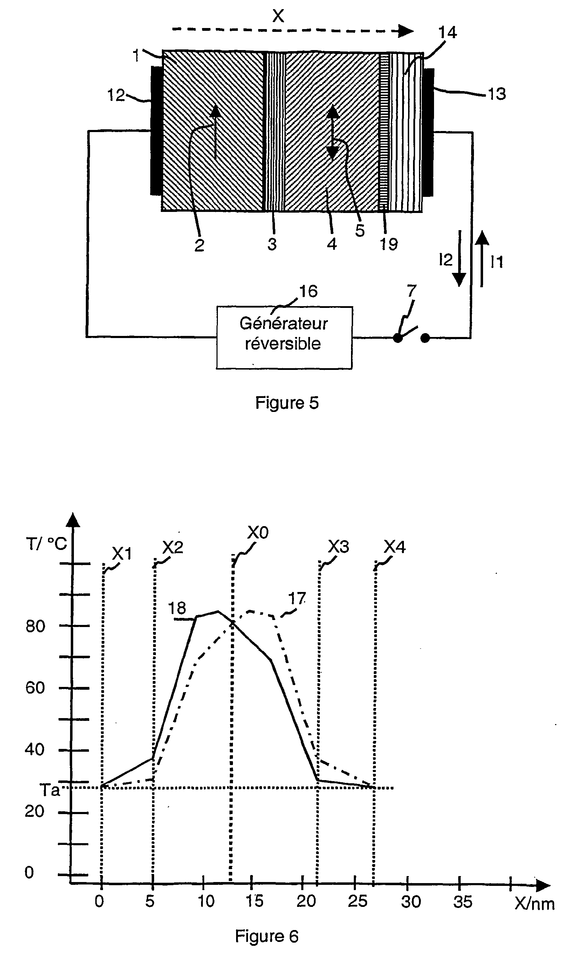

Lorsque la première barrière thermique est constituée par une couche magnétique, par exemple antiferromagnétique, une couche 19 de découplage magnétique peut être disposée entre la première barrière thermique, constituée par la couche 14, et la couche de stockage 4, comme représenté à la figure 5, afin de découpler la barrière thermique magnétique de la couche de stockage 4. Le matériau de la couche 19 de découplage magnétique peut être un matériau non-magnétique choisi parmi le tantale, le chrome, le vanadium, le manganèse et le platine. Dans le cas d'une deuxième barrière thermique antiferromagnétique, un découplage magnétique entre la deuxième barrière thermique et la couche de référence n'est pas nécessaire, car l'aimantation de la couche de référence est piégée.

Dans le mode de réalisation particulier représenté à la figure 5, une troisième barrière thermique est constituée par la barrière tunnel 3 elle-même. Par exemple la barrière tunnel peut être en oxyde de silicium (Si0₂), oxyde de zirconium (Zr0₂) ou oxyde de titane (Ti0₂). Les conductivités thermiques de l'oxyde de zirconium et de l'oxyde de titane sont respectivement 1,5W/m/°C et 7,4W/m/°C.

La variation de température dans un dispositif selon l'art antérieur a été étudiée. Ainsi, la figure 6 représente deux distributions de température théoriques dans un dispositif magnétique comportant une jonction tunnel magnétique selon l'art antérieur, respectivement pour un courant circulant de la couche de stockage 4 vers la couche de référence 1 (courbe 17) et dans le sens inverse (courbe 18). Afin de faire ressortir la symétrie du profil de température généré par le passage du courant, la structure de cet exemple a été volontairement choisie symétrique. Le dispositif comporte successivement, selon l'axe X, entre la première électrode 12 et la seconde électrode 13 :
- une couche de tantale (Ta) d'une épaisseur de 5 nm disposée dans l'intervalle compris entre X1 et X2 sur la figure 6,
- un empilement d'une couche de 5nm de IrMn et d'une couche de 3nm de NiFe constituant la couche de référence 1 (X2-X0),
- une couche d'alumine de 0,6nm constituant la barrière tunnel 3, représentée, de par sa finesse, par la ligne pointillée disposée à X0,
- un empilement d'une couche de 3nm de NiFe et d'une couche de 5nm de IrMn constituant la couche de stockage 4 (X0-X3)
- et d'une couche de Ta d'une épaisseur de 5 nm (X3-X4).
Le dispositif est alors symétrique par rapport à la coordonnée X0 et ne comporte pas de barrière thermique. Les courbes 17 et 18 sont obtenues pour une jonction tunnel connectée à ces bornes à deux électrodes de cuivre, maintenues à température ambiante et ayant une différence de potentiel de 0,5V.

On observe sur la figure 6 une asymétrie des distributions de température 17 et 18. En effet, un courant circulant de la couche de stockage 4 vers la couche de référence 1 (courbe 17) correspond à un mouvement d'électrons de la couche de référence 1 vers la couche de stockage 4 (vers la droite, sur la figure), ce qui implique une dissipation de leur énergie dans la couche de stockage 4 ((X0-X3), c'est-à-dire dans une zone disposée à droite de la barrière tunnel (X0), comme représenté à la figure 2. Ceci est illustré par l'amplitude de la courbe 17, plus importante pour des valeurs de X supérieures à X0 que pour des valeurs inférieures à X0. La courbe 18 correspond à un mouvement d'électrons circulant de la droite vers la gauche sur la figure 6 et créant, ainsi, plus de chaleur pour des valeurs inférieures à X0.

Ainsi, pour un courant donné, la direction du courant permet de définir dans la jonction la couche magnétique 1 ou 4 s'échauffant le plus. Ainsi, on peut réaliser un procédé de lecture/écriture d'un dispositif magnétique selon l'invention. Une phase d'écriture comporte la circulation d'un courant électrique l1 (figure 5), à travers la jonction tunnel, de la couche de stockage 4 vers la couche de référence 1, de manière à échauffer la couche de stockage 4 à une température supérieure à la température de blocage de l'aimantation 5 de la couche de stockage 4, tandis qu'une phase de lecture comporte la circulation d'un courant électrique l2 (figure 5), à travers la jonction tunnel, dans le sens inverse, c'est-à-dire de la couche de référence 1 vers la couche de stockage 4. Ainsi, la couche de stockage 4 est échauffée efficacement pendant les phases d'écriture, tandis que l'échauffement de la couche de stockage 4 pendant les phases de lecture est diminué. Les courants l1 et l2 peuvent, par exemple, être générés par un générateur réversible 16.

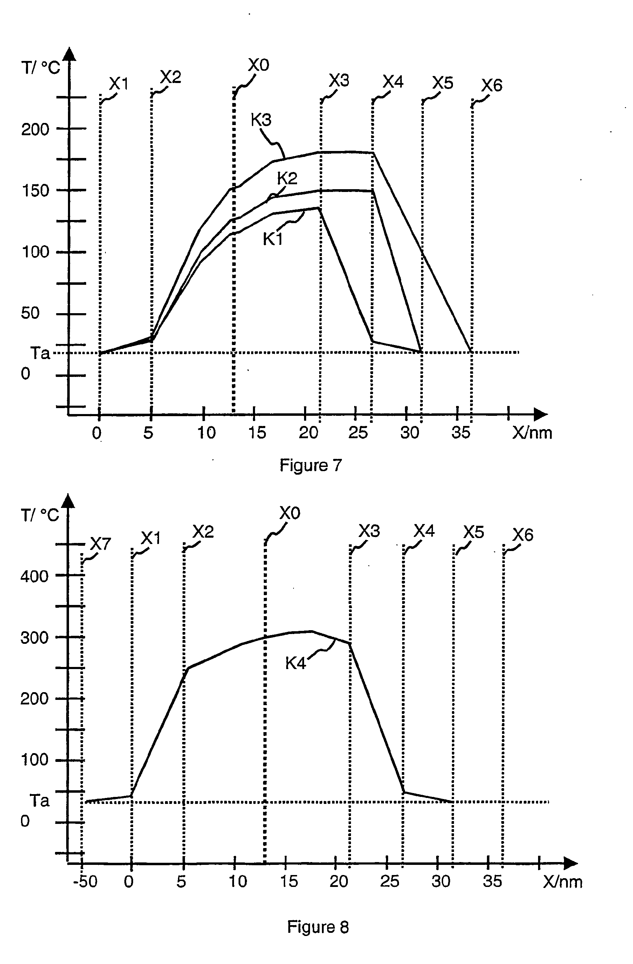

La variation de température dans un dispositif selon l'invention est illustrée aux figures 7 à 9. Les distributions de température théoriques (courbes K1 à K5) représentées aux figures 7 à 9 sont obtenues pour une direction du courant électrique de la couche de stockage 4 vers la couche de référence 1, c'est-à-dire pour un mouvement des électrons de la couche de référence 1 vers la couche de stockage 4, et correspondent ainsi aux phases d'écriture.

Les courbes K1 à K5, ainsi que les courbes 17 et 18, illustrent la distribution de température en fin d'une impulsion de courant d'une durée de 500ps et d'une intensité de 250mA/µm², correspondant à un produit de la résistance R de la jonction tunnel et de la surface S de la jonction tunnel RS=2Ωµm². Pendant la durée de l'impulsion, la température de la jonction s'élève rapidement pour atteindre un régime permanent correspondant au maximum de température. Puis, lorsque le courant est annulé, la température retombe rapidement vers la température ambiante par diffusion de la chaleur vers les électrodes 12 et 13 extérieures qui agissent comme des thermostats.

Les trois courbes K1, K2 et K3 représentées à la figure 7 illustrent l'évolution des distributions de température dans des dispositifs magnétiques selon la figure 3 comportant différentes couches 14. Lesdits dispositifs magnétiques comportent également chacun une couche de tantale, disposée dans l'intervalle comprise entre X1 et X2 sur la figure 7 (non-représentée à la figure 3).

Ainsi, la couche 14 du dispositif magnétique pour la courbe K1 est constituée par un empilement d'une couche de BiTe d'une épaisseur de 5nm (X3-X4) et d'une couche de Ta d'une épaisseur de 5nm (X4-X5), disposées successivement entre la couche de stockage 4 et la seconde électrode 13.

La couche 14 pour la courbe K2 est constituée par un empilement d'une couche de Ta d'une épaisseur de 5nm (X3-X4) et d'une couche de BiTe d'une épaisseur de 5nm (X4-X5), disposées successivement entre la couche de stockage 4 et la seconde électrode 13.

La couche 14 correspondant à la courbe K3 est constituée par un empilement d'une couche de Ta d'une épaisseur de 5nm (X3-X4) et d'une couche de BiTe d'une épaisseur de 10nm (X4-X6), disposées successivement entre la couche de stockage 4 et la seconde électrode 13.

En effet, l'utilisation de barrières thermiques permet d'atteindre des températures comprises entre 100°C et 175°C dans la couche magnétique (X0-X3), donc plus importantes que les températures obtenues dans un dispositif selon l'art antérieur (figure 6, courbe 17, toujours nettement inférieure à 100°C). L'efficacité de la barrière thermique est d'autant meilleure que son épaisseur est importante. En effet, la courbe K3 est supérieure à la courbe K2. Cependant, l'épaisseur de la barrière thermique limite la cinétique de la diminution de température une fois que le courant est annulé.

Par ailleurs, afin de réduire la consommation électrique nécessaire pour l'échauffement, la couche de stockage 4 a, de préférence, une épaisseur faible, par exemple de l'ordre de 8nm.

Les distributions de température représentées par les courbes K1 à K3 sont obtenues pour une barrière tunnel 3 en alumine. L'alumine étant un bon conducteur thermique, la chaleur produite dans la couche de stockage 4 s'évacue en passant à travers la barrière tunnel 3 et la couche de référence 1 vers la première électrode 12. Afin de limiter cette déperdition de chaleur qui nuit à l'efficacité de l'échauffement, il est alors avantageux d'introduire la deuxième barrière thermique, représentée à la figure 4, pour confiner autant que possible la chaleur dans la couche de stockage 4.

La courbe K4 représentée à la figure 8 illustre la distribution de température d'un dispositif comportant une première et une deuxième barrière thermique, constituées respectivement par une couche 14 et une couche 15. La couche 15 est constituée par un empilement d'une couche de 5nm de Ta (X7-X1) et d'une couche de 5 nm de BiTe (X1-X2), disposées successivement entre la première électrode 12 et la souche de référence 1. La couche 14 est identique à la couche 14 correspondant à la courbe K1. La température dans la couche de stockage 4 (X0-X3) est de l'ordre de 300°C, donc plus importante que dans le cas de l'utilisation d'une première barrière thermique uniquement (courbe K1).

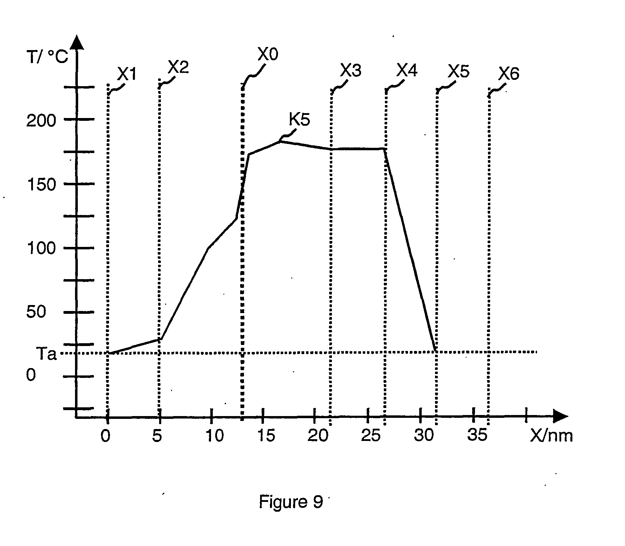

La figure 9 illustre la distribution de température (courbe K5) obtenue pour un dispositif comportant une troisième barrière thermique constituée par la barrière tunnel 3 elle-même et une première barrière thermique constituée par la couche 14. La barrière tunnel 3 est constituée par une couche en silice d'une épaisseur de 0,6nm. La couche 14 et la couche de référence 1 sont respectivement identiques à celles correspondant à la courbe K2. La température dans la couche de stockage 4 (X0-X3) est de l'ordre de 175°C (courbe K5), donc supérieure à la température d'un dispositif ayant une barrière tunnel 3 en alumine (courbe K2) dont la température ne dépasse pas les 150°C. En effet, la silice a une conductivité thermique (1,5W/m/°C) plus faible que l'alumine (36,7W/m/°C) et permet, ainsi, de confiner la chaleur plus efficacement dans la couche de stockage 4.

L'invention n'est pas limitée aux modes de réalisation représentés. En particulier, toute combinaison des première, deuxième et troisième barrières thermiques est possible.

## Revendications (Revendications pour l'(les) Etat(s) contractant(s) suivant(s): AT, BE, CH, DK, ES, FR, GR, IT, LI, LU, MC, NL, SE)

1. Dispositif magnétique comportant successivement
- une première électrode (12),
- une jonction tunnel magnétique comportant successivement une première couche magnétique (1) formant une couche de référence et ayant une aimantation (2) fixe, une couche électriquement isolante constituant une barrière tunnel (3) et une seconde couche magnétique (4) formant une couche de stockage et ayant une aimantation (5) de direction réversible,
- une couche (14) intermédiaire,
- est une seconde électrode (13),
dispositif **caractérisé en ce que** la couche (14) intermédiaire constitue une première barrière thermique constituée par un matériau ayant une conductivité thermique inférieure à 5 W/m/°C.

2. Dispositif selon la revendication 1, **caractérisé en ce qu'**une deuxième barrière thermique est constituée par une couche (15) disposée entre la première électrode (12) et la première couche magnétique (1).

3. Dispositif selon l'une des revendications 1 et 2, **caractérisé en ce que** le matériau des première et/ou deuxième barrières thermiques a une conductivité électrique telle que la résistance électrique de la barrière thermique soit sensiblement plus faible que la résistance électrique de la barrière tunnel (3).

4. Dispositif selon l'une quelconque des revendications 1 à 3, **caractérisé en ce que** le matériau des première et/ou deuxième barrières thermiques comporte au moins un alliage comportant au moins un élément choisi parmi l'arsenic, l'antimoine, le bismuth, le germanium, l'étain et le plomb et comportant au moins un élément choisi parmi le soufre, le sélénium, le tellure, l'aluminium, le gallium, l'indium et le thallium.

5. Dispositif selon l'une quelconque des revendications 1 à 3, **caractérisé en ce que** le matériau des première et/ou deuxième barrières thermiques comporte au moins un alliage comportant au moins un élément choisi parmi le phosphore, l'arsenic et l'antimoine et comportant au moins un élément choisi parmi le fer, le ruthénium, l'osmium, le cobalt, le rhodium, l'iridium et le zinc.

6. Dispositif selon la revendication 5, **caractérisé en ce que** le matériau des première et/ou deuxième barrières thermiques comporte au moins un élément choisi parmi le lanthane, le cérium, le praséodyme, le néodyme, le samarium, l'europium, le gadolinium, le thulium, l'ytterbium, le thorium et l'uranium.

7. Dispositif selon l'une quelconque des revendications 1 à 6, **caractérisé en ce que**, la première barrière thermique étant constituée par une couche antiferromagnétique, le dispositif comporte une couche (19) de découplage magnétique disposée entre la première barrière thermique et la seconde couche magnétique(4).

8. Dispositif selon la revendication 7, **caractérisé en ce que** le matériau de la couche (19) de découplage magnétique est choisi parmi le tantale, le chrome, le vanadium, le manganèse et le platine.

9. Dispositif selon l'une quelconque des revendications 1 à 8, **caractérisé en ce qu'**une troisième barrière thermique est constituée par la barrière tunnel (3).

10. Dispositif selon la revendication 9, **caractérisé en ce que** le matériau de la barrière tunnel (3) est choisi parmi l'oxyde de silicium, l'oxyde de zirconium et l'oxyde de titane.

11. Dispositif selon une quelconque des revendications 1 à 10, **caractérisé en ce que** la première barrière thermique est en contact avec le second couche magnétique de la jonction tunnel et/ou la seconde barrière thermique est en contact la première couche magnétique de la jonction tunnel.

12. Dispositif selon une quelconque des revendications 1 à 11 **caractérisé en ce que** la seconde couche magnétique est constituée d'une couche unique.

13. Dispositif selon une quelconque des revendications 1 à 11 **caractérisé en ce que** la seconde couche magnétique est constituée d'une multicouche.

14. Dispositif selon une quelconque des revendications 1 à 13, **caractérisé en ce que** le matériau de la première et/ou la deuxième barrière thermique est un alliage de bismuth et de tellure.

15. Dispositif selon une quelconque des revendications 1 à 13, **caractérisé en ce que** le matériau de la première et/ou la deuxième barrière thermique est un alliage de thallium, d'étain et de tellure.

16. Dispositif selon une quelconque des revendications 1 à 13, **caractérisé en ce que** le matériau de la première et/ou la deuxième barrière thermique est un alliage de thallium, de bismuth et de tellure.

17. Dispositif selon une quelconque des revendications 1 à 13, **caractérisé en ce que** le matériau de la première et/ou la deuxième barrière thermique est un alliage strontium, de gallium et de germanium.

18. Dispositif selon une quelconque des revendications 1 à 13, **caractérisé en ce que** le matériau de la première et/ou la deuxième barrière thermique est un alliage de strontium, d'europium, de gallium et de germanium.

19. Procédé de lecture/écriture d'un dispositif magnétique selon l'une quelconque des revendications 1 à 18, **caractérisé en ce que** une phase d'écriture comporte la circulation d'un courant électrique (11), à travers la jonction tunnel, de la seconde couche magnétique (4) vers la première couche magnétique (1), de manière à échauffer la seconde couche magnétique (4) à une température supérieure à la température de blocage de l'aimantation (5) de la seconde couche magnétique (4), et une phase de lecture comporte la circulation d'un courant électrique(12), à travers la jonction tunnel, de la première couche magnétique (1) vers la seconde couche magnétique (4).

## Revendications (Revendications pour l'(les) Etat(s) contractant(s) suivant(s): DE, GB)

1. Dispositif magnétique comportant successivement
une première électrode (12),
une jonction tunnel magnétique comportant successivement une première couche magnétique (1) formant une couche de référence et ayant une aimantation (2) fixe, une couche électriquement isolante constituant une barrière tunnel (3) et une seconde couche magnétique (4) formant une couche de stockage et ayant une aimantation (5) de direction réversible,
- une couche (14) intermédiaire formant une première barrière thermique,
- et une seconde électrode (13),
le dispositif est **caractérisé en ce que** la couche intermédiaire (14) est constituée par un matériau ayant une conductivité thermique inférieure à 5 W/m/°C et **en ce que** (i) le matériau de la première barrière thermique comporte au moins un alliage comportant au moins un élément choisi parmi l'arsenic, l'antimoine, le bismuth, le germanium, l'étain et le plomb et au moins un élément choisi parmi le soufre, le sélénium, le tellure, l'aluminium, le gallium, l'indium et le thallium ; ou (ii) le matériau de la première barrière thermique comporte au moins un alliage comportant au moins un élément choisi parmi le phosphore, l'arsenic et l'antimoine et au moins un élément choisi parmi le fer, le ruthénium, l'osmium, le cobalt, le rhodium, l'iridium et le zinc

2. Dispositif magnétique comportant successivement
une première électrode (12),
une jonction tunnel magnétique comportant successivement une première couche magnétique (1) formant une couche de référence et ayant une aimantation (2) fixe, une couche électriquement isolante constituant une barrière tunnel (3) et une seconde couche magnétique (4) formant une couche de stockage et ayant une aimantation (5) de direction réversible,
- une couche (14) intermédiaire formant une première barrière thermique,
- et une seconde électrode (13),
le dispositif est **caractérisé en ce que** la couche intermédiaire est constituée par un matériau ayant une conductivité thermique inférieure à 5 W/m/°C et **en ce que** la première barrière thermique est constituée par une couche antiferromagnétique associée à une couche (19) de découplage magnétique disposée entre la première barrière thermique et la seconde couche magnétique (4) en étant en contact physique avec cette première barrière thermique afin de découpler la première barrière thermique de la seconde couche magnétique.

3. Dispositif magnétique selon la revendication 1 ou 2, **caractérisé en ce que** le matériau de la première barrière thermique comporte au moins un alliage comportant au moins un élément choisi parmi le phosphore, l'arsenic et l'antimoine et comportant au moins un élément choisi parmi le fer, le ruthénium, l'osmium, le cobalt, le rhodium, l'iridium et le zinc et au moins un élément choisi parmi le lanthane, le cérium, le praséodyme, le néodyme, le samarium, l'europium, le gadolinium, le thalium, l'ytterbium, le thorium et l'uranium.

4. Dispositif magnétique selon la revendication 1, 2 ou 3 caractérisé en que le matériau de la première barrière thermique a une conductivité électrique telle que la résistance électrique de la barrière thermique soit sensiblement plus faible que la résistance électrique de la barrière tunnel (3).

5. Dispositif selon l'une quelconque des revendications 1,2, 3, ou 4 **caractérisé en ce qu'**une deuxième barrière thermique est constituée par une couche (15) disposée entre la première électrode (12) et la première couche magnétique (1), cette deuxième barrière thermique comporte au moins un alliage comportant au moins un élément choisi parmi l'arsenic, l'antimoine, le bismuth, le germanium, l'étain et le plomb et comportant au moins un élément choisi parmi le soufre, le sélénium, le tellure, l'aluminium, le gallium, l'indium et le thallium ou au moins un alliage comportant au moins un élément choisi parmi le phosphore, l'arsenic et l'antimoine et comportant au moins un élément choisi parmi le fer, le ruthénium, l'osmium, le cobalt, le rhodium, l'iridium et le zinc.

6. Dispositif selon la revendication 5, **caractérisé en ce que** le matériau de la deuxième barrière thermique a une conductivité électrique telle que la résistance électrique de la deuxième barrière thermique soit sensiblement plus faible que la résistance électrique de la barrière tunnel (3).

7. Dispositif selon l'une quelconque des revendications 1,2, 4 à 6 , **caractérisé en ce que** le matériau de la couche (19) de découplage magnétique est choisi parmi le tantale, le chrome, le vanadium, le manganèse et le platine.

8. Dispositif selon l'une quelconque des revendications 1 à 7, **caractérisé en ce qu'**une troisième barrière thermique est constituée par la barrière tunnel (3).

9. Dispositif selon la revendication 8, **caractérisé en ce que** le matériau de la barrière tunnel (3) est choisi parmi l'oxyde de silicium, l'oxyde de zirconium et l'oxyde de titane.

10. Dispositif selon une quelconque des revendications 1 à 9, **caractérisé en ce que** la première barrière thermique est en contact avec la seconde couche magnétique de la jonction tunnel et/ou la seconde barrière thermique est en contact avec la première couche magnétique de la jonction tunnel.

11. Dispositif selon une quelconque des revendications 1 à 10, **caractérisé en ce que** la seconde couche magnétique est constituée d'une couche unique.

12. Dispositif selon une quelconque des revendications 1 à 10, **caractérisé en ce que** la seconde couche magnétique est constituée d'une multicouche.

13. Dispositif selon une quelconque des revendications 1,2, 4, 5 à 12, **caractérisé en ce que** le matériau de la première et/ou la deuxième barrière thermique est un alliage de bismuth et de tellure.

14. Dispositif selon une quelconque des revendications 1, 2, 4, 5 à 12 **caractérisé en ce que** le matériau de la première et/ou la deuxième barrière thermique est un alliage de thallium, d'étain et de tellure.

15. Dispositif selon une quelconque des revendications 1, 2, 4, 5 à 12, **caractérisé en ce que** le matériau de la première et/ou la deuxième barrière thermique est un alliage de thallium, de bismuth et de tellure.

16. Dispositif selon une quelconque des revendications 1, 2, 4, 5 à 12, **caractérisé en ce que** le matériau de la première et/ou la deuxième barrière thermique est un alliage strontium, de gallium et de germanium.

17. Dispositif selon une quelconque des revendications 1 à 12, **caractérisé en ce que** le matériau de la première et/ou la deuxième barrière thermique est un alliage de strontium, d'europium, de gallium et de germanium.

18. Procédé de lecture/écriture d'un dispositif magnétique selon l'une quelconque des revendications 1 à 17, **caractérisé en ce que** une phase d'écriture comporte la circulation d'un courant électrique (11), à travers la jonction tunnel, de la seconde couche magnétique (4) vers la première couche magnétique (1), de manière à échauffer la seconde couche magnétique (4) à une température supérieure à la température de blocage de l'aimantation (5) de la seconde couche magnétique (4), et une phase de lecture comporte la circulation d'un courant électrique (12), à travers la jonction tunnel, de la première couche magnétique (1) vers la seconde couche magnétique (4).

## Patentansprüche (Patentansprüche für folgende(n) Vertragsstaat(en): AT, BE, CH, DK, ES, FR, GR, IT, LI, LU, MC, NL, SE)

1. Magnetische Vorrichtung, die aufeinanderfolgend umfasst
- eine erste Elektrode (12),
- einen Magnettunnelübergang, der aufeinanderfolgend eine erste magnetische Schicht (1), die eine Referenzschicht bildet und eine feste Magnetisierung (2) aufweist, eine elektrische Isolierschicht, die eine Tunnelbarriere (3) bildet, und eine zweite magnetische Schicht (4), die eine Speicherschicht bildet und eine Magnetisierung (5) mit umkehrbarer Richtung aufweist, umfasst,
- eine Zwischenschicht (14),
- und eine zweite Elektrode (13),
wobei die Vorrichtung **dadurch gekennzeichnet ist, dass** die Zwischenschicht (14) eine erste thermische Barriere bildet, die durch ein Material gebildet ist, das eine Wärmeleitfähigkeit aufweist, die kleiner als 5 W/m/°C ist.

2. Vorrichtung nach Anspruch 1, **dadurch gekennzeichnet, dass** eine zweite thermische Barriere durch eine Schicht (15) gebildet ist, die zwischen der ersten Elektrode (12) und der ersten magnetischen Schicht (1) angeordnet ist.

3. Vorrichtung nach den Ansprüchen 1 und 2, **dadurch gekennzeichnet, dass** das Material der ersten und/oder zweiten thermischen Barriere eine solche elektrische Leitfähigkeit aufweist, dass der elektrische Widerstand der thermischen Barriere wesentlich schwächer als der elektrische Widerstand der Tunnelbarriere (3) ist.

4. Vorrichtung nach den Ansprüchen 1 bis 3, **dadurch gekennzeichnet, dass** das Material der ersten und/oder zweiten thermischen Barriere zumindest eine Legierung umfasst, die zumindest ein Element umfasst, das gewählt ist aus Arsen, Antimon, Wismut, Germanium, Zinn und Blei, und zumindest ein Element umfasst, das gewählt ist aus Schwefel, Selen, Tellur, Aluminium, Gallium, Indium und Thallium.

5. Vorrichtung nach den Ansprüchen 1 bis 3, **dadurch gekennzeichnet, dass** das Material der ersten und/oder zweiten thermischen Barriere zumindest eine Legierung umfasst, die zumindest ein Element umfasst, das gewählt ist aus Phosphor, Arsen und Antimon, und zumindest ein Element umfasst, das gewählt ist aus Eisen, Ruthenium, Osmium, Cobalt, Rhodium, Iridium und Zink.

6. Vorrichtung nach Anspruch 5, **dadurch gekennzeichnet, dass** das Material der ersten und/oder zweiten thermischen Barriere zumindest ein Element umfasst, das gewählt ist aus Lanthan, Cer, Praseodym, Neodym, Samarium, Europium, Gadolinium, Thulium, Ytterbium, Thorium und Uran.

7. Vorrichtung nach den Ansprüchen 1 bis 6, **dadurch gekennzeichnet, dass** die erste thermische Barriere durch eine antiferromagnetische Schicht gebildet ist, wobei die Vorrichtung eine magnetische Entkopplungsschicht (19) umfasst, die zwischen der ersten thermischen Barriere und der zweiten magnetischen Schicht (4) angeordnet ist.

8. Vorrichtung nach Anspruch 7, **dadurch gekennzeichnet, dass** das Material der magnetischen Entkopplungsschicht (19) gewählt ist aus Tantal, Chrom, Vanadium, Mangan und Platin.

9. Vorrichtung nach einem der Ansprüche 1 bis 8, **dadurch gekennzeichnet, dass** durch die Tunnelbarriere (3) eine dritte thermische Barriere gebildet ist.

10. Vorrichtung nach Anspruch 9, **dadurch gekennzeichnet, dass** das Material der Tunnelbarriere (3) gewählt ist aus Siliciumoxid, Zirconiumoxid und Titanoxid.

11. Vorrichtung nach einem der Ansprüche 1 bis 10, **dadurch gekennzeichnet, dass** die erste thermische Barriere mit der zweiten magnetischen Schicht des Tunnelübergangs in Kontakt steht und/oder die zweite thermische Barriere mit der ersten magnetischen Schicht des Tunnelübergangs in Kontakt steht.

12. Vorrichtung nach einem der Ansprüche 1 bis 11, **dadurch gekennzeichnet, dass** die zweite magnetische Schicht aus einer einzigen Schicht gebildet ist.

13. Vorrichtung nach einem der Ansprüche 1 bis 11, **dadurch gekennzeichnet, dass** die zweite magnetische Schicht aus einer Mehrfachschicht gebildet ist.

14. Vorrichtung nach einem der Ansprüche 1 bis 13, **dadurch gekennzeichnet, dass** das Material der ersten und/oder der zweiten thermischen Barriere eine Legierung aus Wismut und Tellur ist.

15. Vorrichtung nach einem der Ansprüche 1 bis 13, **dadurch gekennzeichnet, dass** das Material der ersten und/oder der zweiten thermischen Barriere eine Legierung aus Thallium, Zinn und Tellur ist.

16. Vorrichtung nach einem der Ansprüche 1 bis 13, **dadurch gekennzeichnet, dass** das Material der ersten und/oder der zweiten thermischen Barriere eine Legierung aus Thallium, Wismut und Tellur ist.

17. Vorrichtung nach einem der Ansprüche 1 bis 13, **dadurch gekennzeichnet, dass** das Material der ersten und/oder der zweiten thermischen Barriere eine Legierung aus Strontium, Gallium und Germanium ist.

18. Vorrichtung nach einem der Ansprüche 1 bis 13, **dadurch gekennzeichnet, dass** das Material der ersten und/oder der zweiten thermischen Barriere eine Legierung aus Strontium, Europium, Gallium und Germanium ist.

19. Verfahren zum Lesen/Schreiben einer magnetischen Vorrichtung nach einem der Ansprüche 1 bis 18, **dadurch gekennzeichnet, dass** eine Schreibphase das Durchleiten eines elektrischen Stromes (11) durch den Tunnelübergang, die zweite magnetische Schicht (4) in Richtung der ersten magnetischen Schicht (1) in der Weise umfasst, dass die zweite magnetische Schicht (4) auf eine höhere Temperatur als die Sperrtemperatur der Magnetisierung (5) der zweiten magnetischen Schicht (4) erwärmt wird, und eine Lesephase das Durchleiten eines elektrischen Stromes (12) durch den Tunnelübergang, die erste magnetische Schicht (1) in Richtung der zweiten magnetischen Schicht (4) umfasst.

## Patentansprüche (Patentansprüche für folgende(n) Vertragsstaat(en): DE, GB)

1. Magnetische Vorrichtung, die aufeinanderfolgend umfasst
eine erste Elektrode (12),
einen Magnettunnelübergang, der aufeinanderfolgend eine erste magnetische Schicht (1), die eine Referenzschicht bildet und eine feste Magnetisierung (2) aufweist, eine elektrische Isolierschicht, die eine Tunnelbarriere (3) bildet, und eine zweite magnetische Schicht (4), die eine Speicherschicht bildet und eine Magnetisierung (5) mit umkehrbarer Richtung aufweist, umfasst,
- eine Zwischenschicht (14), die eine erste thermische Barriere bildet,
- und eine zweite Elektrode (13),
wobei die Vorrichtung **dadurch gekennzeichnet ist, dass** die Zwischenschicht (14) durch ein Material gebildet ist, das eine Wärmeleitfähigkeit aufweist, die kleiner als 5 W/m/°C ist, und dass (i) das Material der ersten thermischen Barriere zumindest eine Legierung umfasst, die zumindest ein Element umfasst, das gewählt ist aus Arsen, Antimon, Wismut, Germanium, Zinn und Blei und zumindest ein Element, das gewählt ist aus Schwefel, Selen, Tellur, Aluminium, Gallium, Indium und Thallium; oder (ii) das Material der ersten thermischen Barriere zumindest eine Legierung umfasst, die zumindest ein Element umfasst, das gewählt ist aus Phosphor, Arsen und Antimon, und zumindest ein Element, das gewählt ist aus Eisen, Ruthenium, Osmium, Cobalt, Rhodium, Iridium und Zink.

2. Magnetische Vorrichtung, die aufeinanderfolgend umfasst
eine erste Elektrode (12),
einen Magnettunnelübergang, der aufeinanderfolgend eine erste magnetische Schicht (1), die eine Referenzschicht bildet und eine feste Magnetisierung (2) aufweist, eine elektrische Isolierschicht, die eine Tunnelbarriere (3) bildet, und eine zweite magnetische Schicht (4), die eine Speicherschicht bildet und eine Magnetisierung (5) mit umkehrbarer Richtung aufweist, umfasst,
- eine Zwischenschicht (14), die eine erste thermische Barriere bildet,
- und eine zweite Elektrode (13),
wobei die Vorrichtung **dadurch gekennzeichnet ist, dass** die Zwischenschicht (14) durch ein Material gebildet ist, das eine Wärmeleitfähigkeit aufweist, die kleiner als 5 W/m/°C ist, und dass die erste thermische Barriere durch eine antiferromagnetische Schicht gebildet ist, die einer magnetischen Entkopplungsschicht (19) zugeordnet ist, die zwischen der ersten thermischen Barriere und der zweiten magnetischen Schicht (4) angeordnet ist und dabei in physikalischem Kontakt mit dieser ersten thermischen Barriere steht, um die erste thermische Barriere von der zweiten magnetischen Schicht zu entkoppeln.

3. Magnetische Vorrichtung nach Anspruch 1 oder 2, **dadurch gekennzeichnet, dass** das Material der ersten thermischen Barriere zumindest eine Legierung umfasst, die zumindest ein Element umfasst, das gewählt ist aus Phosphor, Arsen und Antimon, und zumindest ein Element umfasst, das gewählt ist aus Eisen, Ruthenium, Osmium, Cobalt, Rhodium, Iridium und Zink, und zumindest ein Element, das gewählt ist aus Lanthan, Cer, Praseodym, Neodym, Samarium, Europium, Gadolinium, Thulium, Ytterbium, Thorium und Uran.

4. Magnetische Vorrichtung nach Anspruch 1, 2 oder 3, **dadurch gekennzeichnet, dass** das Material der ersten thermischen Barriere eine solche elektrische Leitfähigkeit aufweist, dass der elektrische Widerstand der thermischen Barriere wesentlich schwächer als der elektrische Widerstand der Tunnelbarriere (3) ist.

5. Vorrichtung nach einem der Ansprüche 1, 2, 3 oder 4, **dadurch gekennzeichnet, dass** eine zweite thermische Barriere durch eine Schicht (15) gebildet ist, die zwischen der ersten Elektrode (12) und der ersten magnetischen Schicht (1) angeordnet ist, wobei diese zweite thermische Barriere zumindest eine Legierung umfasst, die zumindest ein Element umfasst, das gewählt ist aus Arsen, Antimon, Wismut, Germanium, Zinn und Blei, und zumindest ein Element umfasst, das gewählt ist aus Schwefel, Selen, Tellur, Aluminium, Gallium, Indium und Thallium oder zumindest eine Legierung, die zumindest ein Element umfasst, das gewählt ist aus Phosphor, Arsen und Antimon, und zumindest ein Element umfasst, das gewählt ist aus Eisen, Ruthenium, Osmium, Cobalt, Rhodium, Iridium und Zink.

6. Vorrichtung nach Anspruch 5, **dadurch gekennzeichnet, dass** das Material der zweiten thermischen Barriere eine solche elektrische Leitfähigkeit aufweist, dass der elektrische Widerstand der zweiten thermischen Barriere wesentlich schwächer als der elektrische Widerstand der Tunnelbarriere (3) ist.

7. Vorrichtung nach einem der Ansprüche 1, 2, 4 bis 6, **dadurch gekennzeichnet, dass** das Material der magnetischen Entkopplungsschicht (19) gewählt ist aus Tantal, Chrom, Vanadium, Mangan und Platin.

8. Vorrichtung nach einem der Ansprüche 1 bis 7, **dadurch gekennzeichnet, dass** durch die Tunnelbarriere (3) eine dritte thermische Barriere gebildet ist.

9. Vorrichtung nach Anspruch 8, **dadurch gekennzeichnet, dass** das Material der Tunnelbarriere (3) gewählt ist aus Siliciumoxid, Zirconiumoxid und Titanoxid.

10. Vorrichtung nach einem der Ansprüche 1 bis 9, **dadurch gekennzeichnet, dass** die erste thermische Barriere mit der zweiten magnetischen Schicht des Tunnelübergangs in Kontakt steht und/oder die zweite thermische Barriere mit der ersten magnetischen Schicht des Tunnelübergangs in Kontakt steht.

11. Vorrichtung nach einem der Ansprüche 1 bis 10, **dadurch gekennzeichnet, dass** die zweite magnetische Schicht aus einer einzigen Schicht gebildet ist.

12. Vorrichtung nach einem der Ansprüche 1 bis 10, **dadurch gekennzeichnet, dass** die zweite magnetische Schicht aus einer Mehrfachschicht gebildet ist.

13. Vorrichtung nach einem der Ansprüche 1, 2, 4, 5 bis 12, **dadurch gekennzeichnet, dass** das Material der ersten und/oder der zweiten thermischen Barriere eine Legierung aus Wismut und Tellur ist.

14. Vorrichtung nach einem der Ansprüche 1, 2, 4, 5 bis 12, **dadurch gekennzeichnet, dass** das Material der ersten und/oder der zweiten thermischen Barriere eine Legierung aus Thallium, Zinn und Tellur ist.

15. Vorrichtung nach einem der Ansprüche 1, 2, 4, 5 bis 12, **dadurch gekennzeichnet, dass** das Material der ersten und/oder der zweiten thermischen Barriere eine Legierung aus Thallium, Wismut und Tellur ist.

16. Vorrichtung nach einem der Ansprüche 1, 2, 4, 5 bis 12, **dadurch gekennzeichnet, dass** das Material der ersten und/oder der zweiten thermischen Barriere eine Legierung aus Strontium, Gallium und Germanium ist.

17. Vorrichtung nach einem der Ansprüche 1 bis 12, **dadurch gekennzeichnet, dass** das Material der ersten und/oder der zweiten thermischen Barriere eine Legierung aus Strontium, Europium, Gallium und Germanium ist.

18. Verfahren zum Lesen/Schreiben einer magnetischen Vorrichtung nach einem der Ansprüche 1 bis 17, **dadurch gekennzeichnet, dass** eine Schreibphase das Durchleiten eines elektrischen Stromes (11) durch den Tunnelübergang, die zweite magnetische Schicht (4) in Richtung der ersten magnetischen Schicht (1) in der Weise umfasst, dass die zweite magnetische Schicht (4) auf eine höhere Temperatur als die Sperrtemperatur der Magnetisierung (5) der zweiten magnetischen Schicht (4) erwärmt wird, und eine Lesephase das Durchleiten eines elektrischen Stromes (12) durch den Tunnelübergang, die erste magnetische Schicht (1) in Richtung der zweiten magnetischen Schicht (4) umfasst.

## Claims (Claims for the following Contracting State(s): AT, BE, CH, DK, ES, FR, GR, IT, LI, LU, MC, NL, SE)

1. Magnetic device successively comprising
- a first electrode (12),
- a magnetic tunnel junction successively comprising a first magnetic layer (1) forming a reference layer and having a fixed magnetization (2), an electrically insulating layer forming a tunnel barrier (3) and a second magnetic layer (4) forming a storage layer and having a reversible direction magnetization (5),
- an intermediate layer (14),
- and a second electrode (13),
device wherein the intermediate layer (14) constitutes a first thermal barrier formed by a material having a thermal conductivity lower than 5 W/m/[deg.] C.

2. Device according to claim 1, wherein a second thermal barrier is formed by a layer (15) arranged between the first electrode (12) and the first layer magnetic (1).

3. Device according to any one of claims 1 or 2, wherein the material of the first and/or second thermal barriers has an electrical conductivity such that the electrical resistance of the thermal barrier is substantially lower than the electrical resistance of the tunnel barrier (3).

4. Device according to any one of claims 1 to 3, wherein the material of the first and/or second thermal barriers comprises at least one alloy containing at least one element chosen from arsenic, antimony, bismuth, germanium, tin and lead and containing at least one element chosen from sulphur, selenium, tellurium, aluminium, gallium, indium and thallium.

5. Device according to any one of claims 1 to 3, wherein the material of the first and/or second thermal barriers comprises at least one alloy containing at least one element chosen from phosphorus, arsenic and antimony and containing at least one element chosen from iron, ruthenium, osmium, cobalt, rhodium, iridium and zinc.

6. Device according to claim 5, wherein the material of the first and/or second thermal barriers comprises at least one element chosen from lanthanum, cerium, praseodymium, neodymium, samarium, europium, gadolinium, thulium, ytterbium, thorium and uranium.

7. Magnetic device according to any one of claims 1 to 6, wherein, the first thermal barrier being formed by an anti-ferromagnetic layer, a magnetic decoupling layer (19) is arranged between the first thermal barrier and the second magnetic layer (4).

8. Device according to claim 7, wherein the material of the magnetic decoupling layer (19) is chosen from tantalum, chromium, vanadium, manganese and platinum.

9. Device according to any one of claims 1 to 8, wherein a third thermal barrier is formed by the tunnel barrier (3).

10. Device according to claim 9, wherein the material of the tunnel barrier (3) is chosen from silicon oxide, zirconium oxide and titanium oxide.

11. Device according to any one of claims 1 to 10, wherein the first thermal barrier is in contact with the second magnetic layer of the tunnel junction and/or the second thermal barrier is in contact with the first magnetic layer of the tunnel junction.

12. Device according to any one of claims 1 to 11, wherein the second magnetic layer is constituted of a single layer.

13. Device according to any one of claims 1 to 11, wherein the second magnetic layer is constituted of a multilayer.

14. Device according to any one of claims 1 to 13, wherein the material of the first and/or second thermal barrier is an alloy of bismuth and tellurium.

15. Device according to any one of claims 1 to 13, wherein the material of the first and/or second thermal barrier is an alloy of thallium, tin and tellurium.

16. Device according to any one of claims 1 to 13, wherein the material of the first and/or second thermal barrier is an alloy of thallium, bismuth and tellurium.

17. Device according to any one of claims 1 to 13, wherein the material of the first and/or second thermal barrier is an alloy of strontium, gallium and germanium.

18. Device according to any one of claims 1 to 13, wherein the material of the first and/or second thermal barrier is an alloy of strontium, europium, gallium and germanium.

19. Read/write method of a magnetic device according to any one of claims 1 to 18, wherein a write phase comprises flow of an electric current (11), through the tunnel junction, from the second magnetic layer (4) to the first magnetic layer (1), so as to heat the second magnetic layer to a higher temperature than the blocking temperature of the magnetization of the second magnetic layer (4), and a read phase comprises flow of an electric current (12), through the tunnel junction, from the first magnetic layer (1) to the second magnetic layer (4).

## Claims (Claims for the following Contracting State(s): DE, GB)

1. Magnetic device successively comprising
- a first electrode (12),
- a magnetic tunnel junction successively comprising a first magnetic layer (1) forming a reference layer and having a fixed magnetization (2), an electrically insulating layer forming a tunnel barrier (3) and a second magnetic layer (4) forming a storage layer and having a reversible direction magnetization (5),
- an intermediate layer (14) forming a first thermal barrier,
- and a second electrode (13),
device wherein the intermediate layer (14) is formed by a material having a thermal conductivity lower than 5 W/m/[deg.] C and wherein (i) the material of the first thermal barrier comprises at least one alloy containing at least one element chosen from arsenic, antimony, bismuth, germanium, tin and lead and at least one element chosen from sulphur, selenium, tellurium, aluminium, gallium, indium and thallium, or (ii) the material of the first thermal barrier comprises at least one alloy containing at least one element chosen from phosphorus, arsenic and antimony and at least one element chosen from iron, ruthenium, osmium, cobalt, rhodium, iridium and zinc.

2. Magnetic device successively comprising
- a first electrode (12),
- a magnetic tunnel junction successively comprising a first magnetic layer (1) forming a reference layer and having a fixed magnetization (2), an electrically insulating layer forming a tunnel barrier (3) and a second magnetic layer (4) forming a storage layer and having a reversible direction magnetization (5),
- an intermediate layer (14) forming a first thermal barrier,
- and a second electrode (13),
device wherein the intermediate layer (14) is formed by a material having a thermal conductivity lower than 5 W/m/[deg.] C and wherein the first thermal barrier is constituted by an anti-ferromagnetic layer associated with a magnetic decoupling layer (19) arranged between the first thermal barrier and the second magnetic layer while being in physical contact with this first thermal barrier so as to decouple the first thermal barrier with respect to the second thermal barrier.

3. Device according to claim 1 or claim 2, wherein the material of the first thermal barrier comprises at least one alloy containing at least one element chosen from phosphorus, arsenic and antimony and containing at least one element chosen from iron, ruthenium, osmium, cobalt, rhodium, iridium and zinc and at least one element chosen from lanthanum, cerium, praseodymium, neodymium, samarium, europium, gadolinium, thullium, ytterbium, thorium and uranium.

4. Device according to any one of claims 1, 2 or 3, wherein the material of the first thermal barrier has an electrical conductivity such that the electrical resistance of the thermal barrier is substantially lower than the electrical resistance of the tunnel barrier (3).

5. Device according to any one of claims 1, 2, 3 or 4, wherein a second thermal barrier is formed by a layer (15) arranged between the first electrode (12) and the first layer magnetic (1), this second thermal barrier comprises at least one alloy containing at least one element chosen from arsenic, antimony, bismuth, germanium, tin and lead and containing at least one element chosen from sulphur, selenium, tellurium, aluminium, gallium, indium and thallium or at least an alloy comprising an element chosen from phosphor, arsenic and antimony and containing at least one element chosen from iron, ruthenium, osmium, cobalt, iridium and zinc.

6. Device according to claim 5, wherein the material of the second thermal barrier has an electrical conductivity such that the electrical resistance of the second thermal barrier is substantially lower than the electrical resistance of the tunnel barrier (3).

7. Magnetic device according to any one of claims 1, 2, 4 to 6, wherein the material of the magnetic decoupling layer (19) is chosen from tantalum, chromium, vanadium, manganese and platinum.

8. Device according to any one of claims 1 to 7, wherein a third thermal barrier is formed by the tunnel barrier (3).

9. Device according to claim 8, wherein the material of the tunnel barrier (3) is chosen from silicon oxide, zirconium oxide and titanium oxide.

10. Device according to any one of claims 1 to 9, wherein the first thermal barrier is in contact with the second magnetic layer of the tunnel junction and/or the second thermal barrier is in contact with the first magnetic layer of the tunnel junction.

11. Device according to any one of claims 1 to 10, wherein the second magnetic layer is constituted of a single layer.

12. Device according to any one of claims 1 to 10, wherein the second magnetic layer is constituted of a multilayer.

13. Device according to any one of claims 1, 2, 4, 5 to 12, wherein the material of the first and/or second thermal barrier is an alloy of bismuth and tellurium.

14. Device according to any one of claims 1 2, 4, 5 to 12, wherein the material of the first and/or second thermal barrier is an alloy of thallium, tin and tellurium.

15. Device according to any one of claims 1, 2, 4, 5 to 12, wherein the material of the first and/or second thermal barrier is an alloy of thallium, bismuth and tellurium.

16. Device according to any one of claims 1, 2, 4, 5 to 12, wherein the material of the first and/or second thermal barrier is an alloy of strontium, gallium and germanium.

17. Device according to any one of claims 1 to 12, wherein the material of the first and/or second thermal barrier is an alloy of strontium, europium, gallium and germanium.

18. Read/write method of a magnetic device according to any one of claims 1 to 17, wherein a write phase comprises flow of an electric current (11), through the tunnel junction, from the second magnetic layer (4) to the first magnetic layer (1), so as to heat the second magnetic layer (4) to a higher temperature than the blocking temperature of the magnetization of the second magnetic layer (4), and a read phase comprises flow of an electric current (12), through the tunnel junction, from the first magnetic layer (1) to the second magnetic layer (4).
